# FASCICULE DE BREVET EUROPEEN

(11) **EP 2 518 898 B1**
(45) Date de publication et mention de la délivrance du brevet: **05.12.2018**
(21) Numéro de dépôt: 12163863.9
(22) Date de dépôt: 12.04.2012
(51) Int. Cl.: H03H 9/02, H03H 9/17, H03H 9/54, H03H 9/64, H03H 9/05, H03H 3/02, H03H 3/08, H03H 9/25

(54) **Dispositif électromécanique à ondes acoustiques comprenant une zone de transduction et une zone de propagation libre représentant une structure résonante**
Elektromechanische Schallwellenvorrichtung, die als Resonator einen Transduktionsbereich und einen Bereich freier Wellenausbreitung umfasst
Electromechanical device with acoustic waves comprising a transduction area and an area of free propagation being a resonant structure

(30) Priorité: 28.04.2011 FR 1153633
(43) Date de publication de la demande: 31.10.2012
(73) Titulaire: COMMISSARIAT À L'ÉNERGIE ATOMIQUE ET AUX ÉNERGIES ALTERNATIVES, 75015 Paris (FR)
(72) Inventeur: Reinhardt, Alexandre, 38400 Saint Martin d'Hères (FR); Defay, Emmanuel, 38340 Voreppe (FR); Perruchot, François, 38000 Grenoble (FR)
(74) Mandataire: Esselin, Sophie

(56) Documents cités:
- FR-A1- 2 905 208
- GB-A- 1 260 525
- US-A- 3 576 453
- US-A- 4 467 235
- US-A1- 2003 127 944
- US-A1- 2007 267 942
- US-A1- 2009 102 316
- US-A1- 2010 123 367
- US-A1- 2010 181 868

## Description

Le domaine de l'invention est celui des dispositifs électromécaniques exploitant la propagation d'ondes acoustiques en vue de réaliser des fonctions de résonateurs électriques, ces résonateurs pouvant à leur tour servir à la réalisation de fonctions plus complexes telles que des filtres, des références de fréquence ou autres. Ces dispositifs présentent des fréquences de fonctionnement pouvant aller de quelques centaines de kHz à quelques GHz.

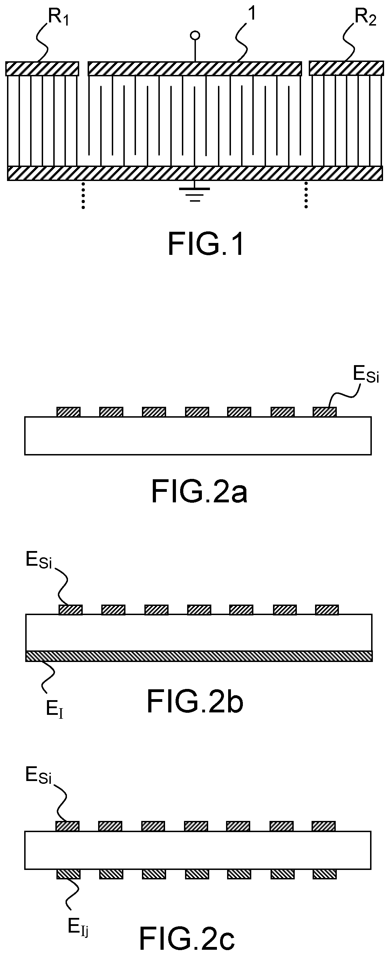

Les résonateurs exploitant la propagation d'ondes acoustiques sont actuellement décomposés en trois grandes familles :
- les résonateurs à ondes de surface, qui exploitent la propagation d'ondes localisées près de la surface d'un substrat piézoélectrique. La transduction entre le signal électrique et les ondes acoustiques s'effectue par le biais d'électrodes en forme de peignes interdigités déposées à la surface du substrat. Des résonateurs sont habituellement réalisés en plaçant un transducteur à peignes interdigités T entre deux réseaux réflecteurs R1 et R2, obtenus en portant des métallisations périodiques au même potentiel. La figure 1 montre un schéma d'un tel résonateur ;
- les résonateurs à ondes de Lamb, ou plus généralement à ondes guidées dans une couche piézoélectrique. Dans ce type de composants, les ondes se propagent dans une plaque, ou dans une partie d'un empilement. La transduction est là aussi assurée par un jeu d'électrodes en forme de peignes interdigités E_{Si} comme illustré en figure 2a, la différence par rapport aux ondes de surface est qu'il est également possible de disposer une ou plusieurs électrodes en face inférieure de la plaque ou de la couche piézoélectrique, ces dernières pouvant être continues Eₗ ou également en forme de peignes interdigités Eₗⱼ comme illustré en figures 2b et 2c. Ces configurations sont notamment décrites dans l'article de J. H. Kuypers, C-M Lin, G. Vigevani et A. Pisano, Intrinsic temperature compensation of Aluminum Nitride Lamb wave resonators for multiple-frequency references, Proceedings of the 2008 IEEE Frequency Control Symposium. voir aussi FR 2 905 208 A1.

Pour définir une cavité résonante, deux configurations sont couramment employées et consistent à utiliser des réseaux réflecteurs composés de peignes interdigités court-circuités (comme pour les résonateurs à ondes de surface), ou à délimiter la plaque (ou la couche faisant office de guide d'onde) de manière à provoquer une réflexion des ondes en bord de plaque (ou de couche) ;
- les résonateurs à ondes de volume, qui exploitent des ondes se propageant verticalement dans un empilement. La transduction est assurée par des électrodes prenant en sandwich une couche piézoélectrique dans le cas le plus général. Dans certaines configurations alternatives, on dispose parfois les deux électrodes côte à côte à la surface de la couche piézoélectrique afin de bénéficier d'une excitation par un champ électrique horizontal plutôt que vertical.

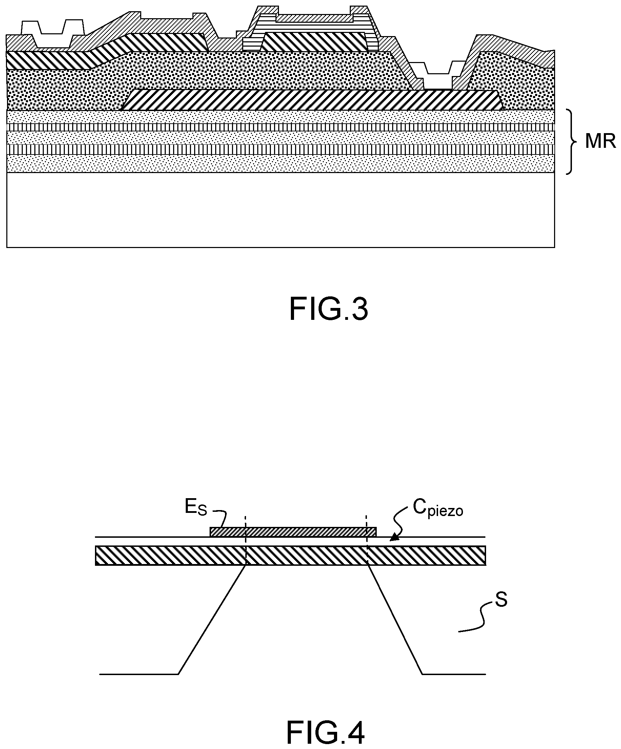

Ces résonateurs se déclinent en deux configurations : la première est appelée *Film Bulk Acoustic Resonator* (FBAR) dans laquelle le résonateur est uniquement constitué de la couche piézoélectrique. On isole alors acoustiquement celle-ci par l'utilisation d'un miroir de Bragg MR composé d'une alternance de couches à la surface d'un substrat S, comme représenté sur l'exemple de la figure 3, ou par la formation d'une cavité d'air sous la couche piézoélectrique C_{piezo} et l'électrode de commande E_{S}, comme illustré sur la figure 4.

La seconde configuration exploite le substrat pour bénéficier des propriétés acoustiques de celui-ci. Généralement, on utilise ce résonateur sur un mode de résonance harmonique, d'où le nom de *High-overtone Bulk Acoustic Resonator* (HBAR) lorsque le substrat est épais. Lorsque le substrat est moins épais, et que l'on utilise une harmonique d'ordre relativement faible (de l'ordre de quelques unités), on parle plutôt de Résonateur Composite.

Les résonateurs HBAR présentent l'avantage de permettre d'obtenir des coefficients de qualité extrêmement élevés à des fréquences de l'ordre du GHz, comme décrit dans l'article de K.M. Lakin, G.R. Kline, R.S. Ketcham, A.R. Landin, W.A. Burkland, K.T. McCarron, S.D. Braymen et S.G. Burns, Thin film resonators technology, Proceedings of the 1987 IEEE International Frequency Control Symposium, p. 371., notamment lorsque le résonateur opère sur une harmonique élevé. Par un choix judicieux du rapport d'épaisseurs entre la cavité résonante (le substrat) et la couche piézoélectrique, on peut ajuster le coefficient de couplage électromécanique d'un résonateur composite comme décrit dans l'article de Z. Wang, Y. Zhang et J.D.N. Cheeke, Characterization of electromechanical coupling coefficients of piezoelectric films using composite resonators, IEEE Transactions on Ultrasonics, Ferroelectrics and Frequency Control vol. 46, n°5, p. 1327, septembre 2009.

On dispose ainsi d'un degré de liberté pour ajuster à la fois le coefficient de qualité du résonateur et son coefficient de couplage électromécanique, même si en règle générale augmenter l'un revient à diminuer l'autre.

Ces deux grandeurs sont particulièrement intéressantes pour l'utilisation de résonateurs dans des systèmes radiofréquence où ils peuvent être utilisés comme éléments d'impédance variable en fréquence dans des filtres passe-bande, ou comme éléments de stabilisation de fréquence dans des oscillateurs. Dans le premier cas, le coefficient de couplage électromécanique définit la largeur de bande atteignable par un filtre (la bande passante relative est de l'ordre de la moitié du coefficient de couplage électromécanique des résonateurs qui le composent), tandis que le coefficient de qualité influe directement sur les pertes de ce même filtre et sur sa sélectivité. Ces deux critères étant antinomiques, un concepteur cherche en général à favoriser l'un au détriment de l'autre. Ceci n'est toutefois pas facilement possible en utilisant les résonateurs de type FBAR, SAW ou les résonateurs à ondes guidées. D'où l'intérêt des résonateurs composites.

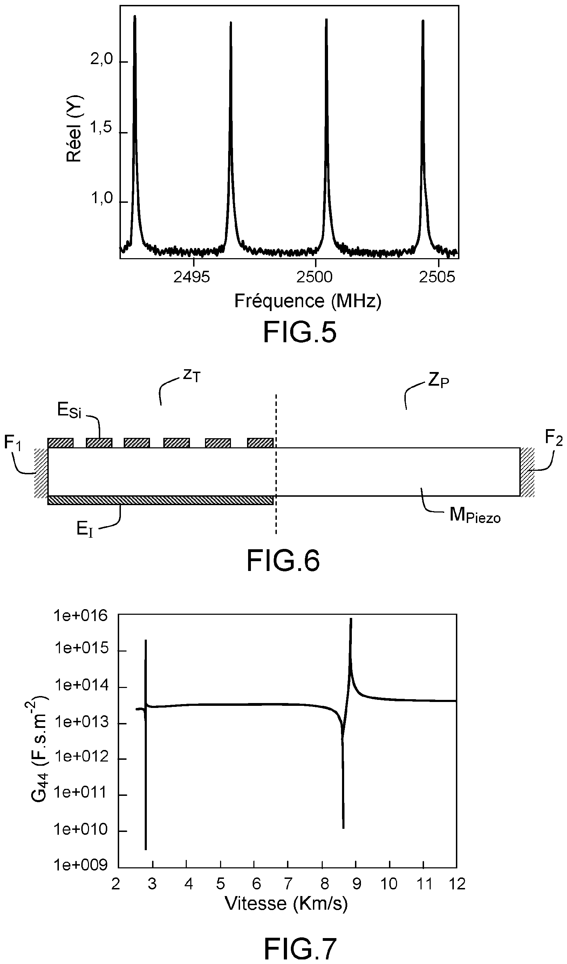

Ces derniers ont cependant un défaut majeur, qui en pratique freine leur utilisation : comme on fait opérer le résonateur sur un mode harmonique, le spectre de ces composants présente toutes les résonances des modes non-utilisés, comme illustré sur la figure 5. La liberté de conception précédemment décrite n'est donc en pratique pas utilisée pour des applications de filtrage où les résonances des harmoniques inutilisés perturbent le fonctionnement du filtre. On se contente donc d'utiliser ces composants pour des applications d'oscillateurs, moins sensibles aux résonances parasites, et où un fort coefficient de qualité est impératif comme décrit dans l'article de J. Masson, G. Martin, R. Boudot, Y. Gruson, S. Ballandras, A. Artieda, P. Murait, B. Belgacem, L. Chommeloux, Fabrication of high stability oscillators using AIN/Si high overtone bulk acoustic resonators, Proceedings of the 2007 IEEE Ultrasonics Symposium, p. 628.

D'autre part, et c'est une caractéristique inhérente aux composants à ondes de volume, les propriétés d'un résonateur HBAR sont fixées par les épaisseurs des couches le composant. Il est donc très difficile de réaliser simultanément des composants ayant des propriétés différentes, car cela nécessiterait l'ajout ou le retrait local de couches permettant la différentiation en fréquence. Cette option est en pratique utilisée pour réaliser deux, voire quatre types de résonateurs différents sur une même structure comme décrit dans l'article de Nam et al., Monolithic 1-chip FBAR duplexer for W-CDMA handsets, Sensors and Actuators A, vol. 143, p. 162 (2008)., mais guère plus, ce qui limite la liberté dans la conception de systèmes.

Dans ce contexte, le principe de la présente invention consiste à exploiter dans un dispositif électromécanique, des ondes de surface ou des ondes se propageant latéralement dans une couche piézoélectrique (ondes de Lamb ou ondes guidées), dans une structure composée d'une zone de transduction, possédant notamment des électrodes surfaciques, et d'une zone de propagation libre complétant la cavité résonante de l'ensemble. Les caractéristiques du résonateur étant grandement fixées par les dimensions latérales du composant, il devient possible de réaliser simultanément des résonateurs possédant des caractéristiques fréquentielles différentes, offrant plus de possibilités de conception que les composants classiques présentés dans l'état de l'art précédemment cité.

Plus précisément, la présente invention a pour objet un dispositif électromécanique selon la revendication 1. Des variantes de l'invention sont définies dans les revendications dépendantes.

L'invention sera mieux comprise et d'autres avantages apparaîtront à la lecture de la description qui va suivre donnée à titre non limitatif et grâce aux figures annexées parmi lesquelles :
- la figure 1 illustre un exemple de résonateur à ondes acoustiques de surface selon l'art connu ;
- les figures 2a, 2b et 2c illustrent des exemples de résonateurs à ondes de Lamb selon l'art connu ;
- la figure 3 illustre un exemple de résonateur à ondes de volume dans une configuration classique utilisant une structure de miroir de Bragg ;
- la figure 4 illustre un exemple de résonateur à ondes de volume formé d'une couche piézoélectrique suspendue selon l'art connu ;
- la figure 5 illustre un exemple de spectre de fréquence d'un résonateur HBAR ;
- la figure 6 illustre un premier exemple de dispositif électromécanique de l'invention utilisant des ondes de Lamb ;
- la figure 7 illustre un exemple de fonction de Green électrostatique pour un empilement AIN / Mo pour une fréquence de 285 MHz ;
- la figure 8 illustre un exemple de la réponse électrique d'un transducteur à ondes de Lamb infini ;
- la figure 9 illustre la réponse électrique large bande d'un transducteur infini et celle d'un dispositif de l'invention comprenant une zone de transduction adjacente à une zone de propagation libre ;
- la figure 10 illustre la réponse électrique d'un dispositif selon l'invention comportant un résonateur à 3 et à 5 doigts ;
- la figure 11 illustre l'influence de la longueur de la zone de propagation libre dans un dispositif électromécanique de l'invention ;
- les figures 12a et 12b illustrent une vue en coupe et une vue de dessus d'un dispositif électromécanique à ondes de Lamb selon l'invention, accordable ;
- la figure 13 illustre la variation de vitesse de l'onde S0 dans la cavité en fonction du rapport entre capacité externe et capacité de la cavité ;
- la figure 14 illustre la variation de vitesse de l'onde S0 dans la cavité en fonction de la valeur d'une inductance variable ;
- la figure 15 illustre la réponse électrique du résonateur à ondes de Lamb en fonction de capacités externes appliquées ;
- la figure 16 illustre un second exemple de dispositif électromécanique selon l'invention comprenant un ensemble de zones discontinues d'adaptation d'impédance ;
- la figure 17 illustre un troisième exemple de dispositif électromécanique selon l'invention comprenant un ensemble de zones discontinues d'adaptation d'impédance de dimensions présentant une progression géométrique ;
- la figure 18 illustre un quatrième exemple de dispositif électromécanique selon l'invention comprenant un ensemble de zones discontinues d'adaptation d'impédance réparties de part et d'autre de la zone de transduction ;
- les figures 19a à 19l illustrent les différentes étapes d'un premier exemple de procédé de fabrication d'un dispositif électromécanique selon l'invention ;
- les figures 20a à 20f illustrent les différentes étapes d'un second exemple de procédé de fabrication d'un dispositif électromécanique selon l'invention ;
- les figures 21a à 21c illustrent des variantes de l'exemple de structure obtenue par les différentes étapes du troisième exemple de fabrication d'un dispositif électromécanique dont les étapes sont illustrées en figures 20a à 20l ;
- les figures 22a à 22h illustrent les différentes étapes d'un troisième procédé de fabrication d'un dispositif électromécanique selon l'invention ;
- les figures 23a et 23b sont relatives à quatrième exemple de dispositif selon l'invention, la figure 23c étant relative à un schéma électrique dudit dispositif obtenu ;
- les figures 24a et 24b illustrent une vue en coupe et une vue de dessus d'un exemple de dispositif électromécanique de l'invention comprenant des zones de réflexions.

De manière générale, le dispositif électromécanique de la présente invention comprend comme représenté de manière schématique en figure 6, une structure plane en matériau piézoélectrique M_{piezo}, comprenant une zone de transduction Z_{T} et au moins une zone de propagation libre Z_{P} pour les ondes acoustiques générées au niveau de la zone de transduction, sur ce schéma. Les bords de la cavité résonante F₁ ou F₂ peuvent correspondre à une délimitation physique de la structure piézoélectrique, une interface milieu de propagation / second milieu pouvant typiquement être le milieu ambiant extérieur audit matériau piézoélectrique de propagation et assurant une réflexion parfaite des ondes acoustiques à toutes les fréquences. Il est également possible d'utiliser un réseau de réflecteurs à peignes interdigités court-circuités, comme couramment utilisé pour les résonateurs SAW.

Selon cet exemple, le dispositif électromécanique comprend un résonateur à ondes de Lamb, générées dans une zone de transduction comportant des peignes d'électrodes interdigitées E_{Si} et une électrode inférieure Eₗ de part et d'autre de la structure piézoélectrique.

Dans une telle structure, la cavité résonante permet de générer plusieurs résonances. En augmentant l'ordre des résonances, on augmente dans le même temps la valeur du coefficient de qualité car la condition de résonance (le déphasage d'une onde lors d'un aller-retour à travers la cavité doit être égal à *2nπ,* avec n l'entier représentant l'ordre de la résonance) devient d'autant plus restrictive sur la fréquence que n augmente (tout autre chose restant égale par ailleurs).

On utilise dans le même temps les propriétés de filtrage du transducteur à peignes interdigités. En effet, le transducteur ne fonctionne efficacement que lorsque la condition de synchronisme (la période des peignes correspond à une demi-longueur d'onde) est approximativement remplie. Par ailleurs, pour des transducteurs possédant un grand nombre de doigts, l'alternance périodique de zones métallisées et non-métallisées produit un effet de miroir de Bragg qui empêche (ou du moins atténue) la propagation des ondes dans une gamme en fréquence proche de la résonance. Naturellement donc, le transducteur vient agir comme un filtre sélectif en fréquence qui vient sélectionner un (ou plusieurs si nécessaire) modes de la cavité résonante. Cet effet est également volontairement exploité dans le cas où des réflecteurs à peignes interdigités court-circuités sont utilisés pour délimiter la cavité résonante. Ces réflecteurs sont dans ce cas efficaces pour des ondes opérant dans une gamme en fréquence donnée et viennent renforcer l'effet de filtrage spectral.

Il est à noter que la zone de transduction peut tout aussi bien ne pas être située en bord de cavité résonante et être localisée au milieu de celle-ci par exemple pour un effet similaire.

Une telle configuration permet de disposer d'un degré de liberté permettant d'ajuster d'un côté le coefficient de qualité du résonateur (fixé par la longueur de la cavité), et de l'autre le coefficient de couplage électromécanique (fixé par le rapport entre la longueur du transducteur et la longueur de la cavité résonante) par rapport aux configurations de l'art connu.

### Premier exemple de dispositif électromécanique selon l'invention :

Le dispositif électromécanique comprend une structure plane de type plaque de nitrure d'aluminium de 2 µm d'épaisseur métallisée par 200 nm de molybdène sur sa face inférieure.

On considère dans un premier temps que les métallisations en face supérieure possèdent une épaisseur négligeable. Des calculs numériques, par exemple de la fonction de Green par la méthode décrite dans l'article de A. Reinhardt, T. Pastureaud, S. Ballandras et V. Laude, Scattering matrix method for modeling acoustic waves in piezoelectric, fluid and metallic multilayers, Journal of Applied Physics vol. 94, n°10, p. 6923, novembre 2003, permettent de déterminer les vitesses du premier mode de Lamb symétrique lorsque la surface est libre ou métallisée.

Le demandeur s'est intéressé notamment à la fonction de Green électrostatique (notée *G₄₄*) qui est une fonction permettant de relier le potentiel électrique à la densité surfacique de charge présente à la surface d'une couche piézoélectrique, en fonction de la vitesse de propagation de l'onde considérée et de la fréquence. Ainsi la fonction de Green illustrée en figure 7, met en évidence des vitesses de phase de 8622 m/s pour l'onde se propageant sous la surface métallisée (où la couche piézoélectrique est branchée en court-circuit, ce qui correspond à un minimum de la fonction de Green) et des vitesses de phase de 8845 m/s lorsque la surface est libre (où la couche piézoélectrique est laissée électriquement flottante, ce qui correspond au maximum de la fonction de Green).

A partir de ces paramètres, on construit un modèle monodimensionnel du résonateur. Ceci peut se faire en utilisant le modèle COM (pour *Coupling of Modes*), la méthode de la matrice mixte, ou bien en construisant un modèle de Mason adapté comme décrit dans l'article de A. Ballato, Modeling piezoelectric and piezomagnetic devices and structures via équivalent networks, IEEE Transactions on Ultrasonics, Ferroelectrics and Frequency Control, vol 48, n°5, p. 1189, septembre 2001.

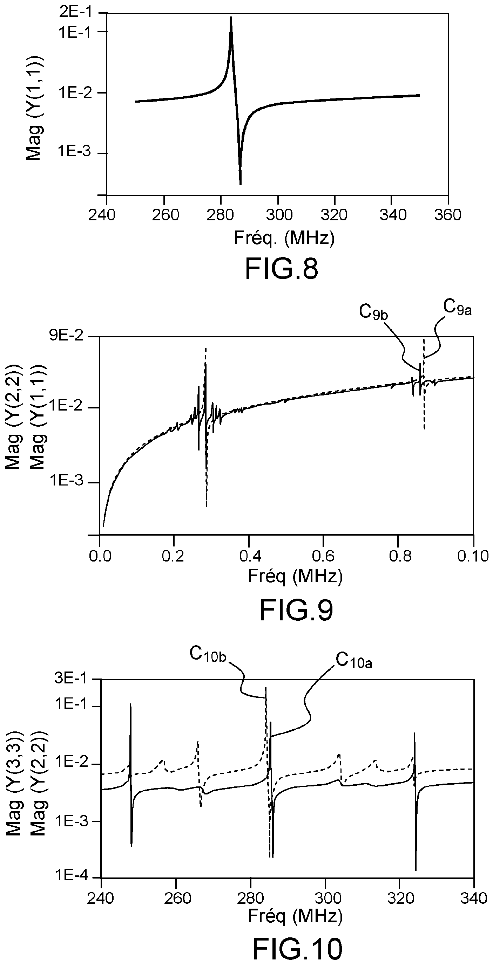

Le Demandeur a dimensionné dans un premier temps un transducteur infini résonant à la fréquence de 285 MHz. Ceci est obtenu pour une période de peignes de p=15,1 µm (soit une demi-longueur d'onde à 285 MHz si on considère une vitesse moyenne entre les deux vitesses utilisées). On considère que la largeur des peignes est de *a*=*p*/*2*=*7,55 µm.* La réponse électrique du transducteur à ondes de Lamb infini est illustrée en figure 8.

Le demandeur a en parallèle dimensionné un dispositif selon l'invention comprenant une zone de transduction adjacente à une zone de propagation libre correspondant à une cavité composée d'une section de membrane constituée d'un nombre entier de longueurs d'onde (soit une longueur *l*=*31* µm ou 62 µm, ou 93 µm, ...).

La réponse électrique d'un dispositif selon l'invention comprenant un transducteur à 5 doigts (soit 2.5 longueurs d'ondes) adjacent à une zone de propagation libre de dimension latérale égale à 5 longueurs d'ondes est représentée sur la figure 9. La réponse électrique large bande d'un transducteur infini est illustrée grâce à la courbe C₉ₐ, Les multiples résonances visibles sur la courbe C_{9b} sont pour partie dues à la formation de résonances dues aux discontinuités acoustiques entre les zones métallisées et non-métallisées et aux différentes résonances pouvant être générées dans la structure, et pour partie dues à la longueur totale du résonateur.

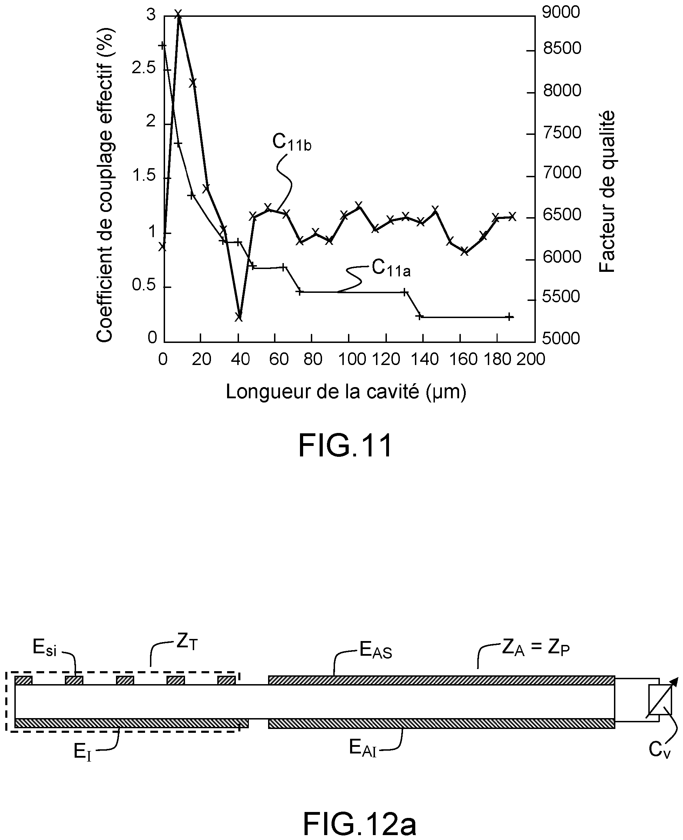

A titre d'exemple la figure 10 montre l'influence du nombre de doigts sur la réponse électrique pour deux résonateurs possédant la même longueur totale (égale à 7,5 longueurs d'onde), seule la proportion entre la longueur de la cavité et la longueur du transducteur ont changé. La courbe C₁₀ₐ est relative à un transducteur comprenant 3 doigts, la courbe C_{10b} étant relative à un transducteur à 5 doigts. On voit en particulier une diminution des résonances proches de la résonance principale pour 3 doigts, due au fait que moins de réflexions internes contribuent à l'établissement de ces résonances, en raison d'un nombre réduit de doigts dans le transducteur. Par contre, les résonances plus lointaines (à 250 et 325 MHz), qui correspondent à des harmoniques établies dans la cavité, sont renforcées car l'effet de filtrage par la périodicité des peignes du transducteur est moindre. On note également que plus le transducteur représente une part importante du résonateur (donc pour 5 doigts), plus le coefficient de couplage électromécanique est élevé, ce qui se traduit par une augmentation de l'espacement en fréquence entre maximum (fréquence de résonance) et minimum (fréquence d'antirésonance) du module de l'admittance, comme pour les résonateurs composites à ondes de volume. Ceci est tout particulièrement visible sur les courbes C₁₁ₐ et C_{11b} de la figure 11 qui présentent respectivement, pour le cas d'un transducteur à 5 doigts d'une période de 4 µm, l'influence de la longueur de la cavité sur le coefficient de couplage effectif et sur le facteur de qualité.

Le Demandeur a en effet également étudié l'évolution du coefficient de qualité, déterminé à partir de pertes de propagation arbitraires. On note pour une cavité de quelques longueurs d'ondes seulement un fort coefficient de qualité, dû à la présence d'une zone non métallisée dans le résonateur, et où les pertes de propagation de l'onde acoustique sont plus faibles. Le coefficient de qualité vient ensuite se stabiliser à une valeur limite qui semble être un compromis entre pertes de propagation de l'onde et accroissement du facteur de qualité par utilisation d'une structure fonctionnant sur un ordre de résonance élevé.

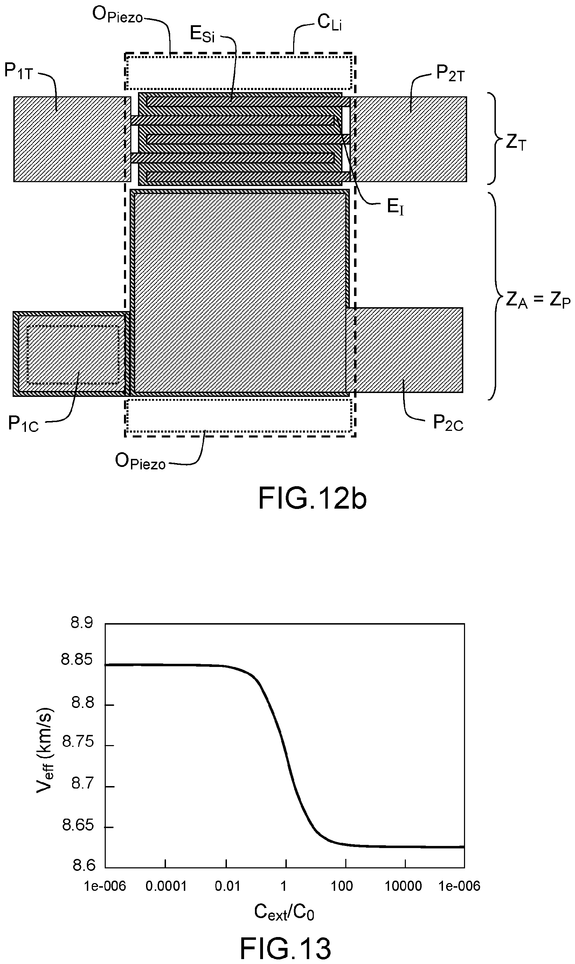

En vue de réaliser un résonateur accordable dynamiquement en fréquence, il est intéressant de venir modifier la vitesse de propagation des ondes dans la cavité en modifiant les conditions aux limites électriques dans cette cavité par l'utilisation d'une charge électrique réactive accordable, comme décrit dans l'article : « Frequency Tuning of Film Bulk Acoustic Resonators » des auteurs Amanda A. Frederick, Hsin-Hua Hu, William W.Clark, University of Pittsburgh, Bendum Hall, Pittsburgh, PA, USA 15261, Proc.of SPIE Vol.6172 6172203, (2006). Les figures 12a et 12b illustrent ainsi respectivement une vue en coupe et une vue de dessus d'une telle structure comprenant une zone de transduction Z_{T} et une zone de propagation libre des ondes Z_{P}, cette zone comprenant en outre une électrode supérieure E_{As} et une électrode inférieure E_{AI} permettant de rendre cette cavité Z_{A} équivalente à une capacité pouvant avantageusement être connectée à une charge extérieure Cᵥ externe de manière à en faire varier les propriétés, avec ainsi Z_{P} = Z_{A}. Plus précisément, la figure 12b met en évidence les plots de connexion de la capacité P_{1C} et P_{2C}, les plots dits RF supérieurs de connexion de la zone de transduction P_{1T} et P_{2T}, les ouvertures O_{piézo} dans le matériau piézoélectrique permettant la reprise de contact de l'électrode inférieure et la délimitation du caisson de libération CLi pour définir la membrane permettant de définir la propagation d'ondes de Lamb.

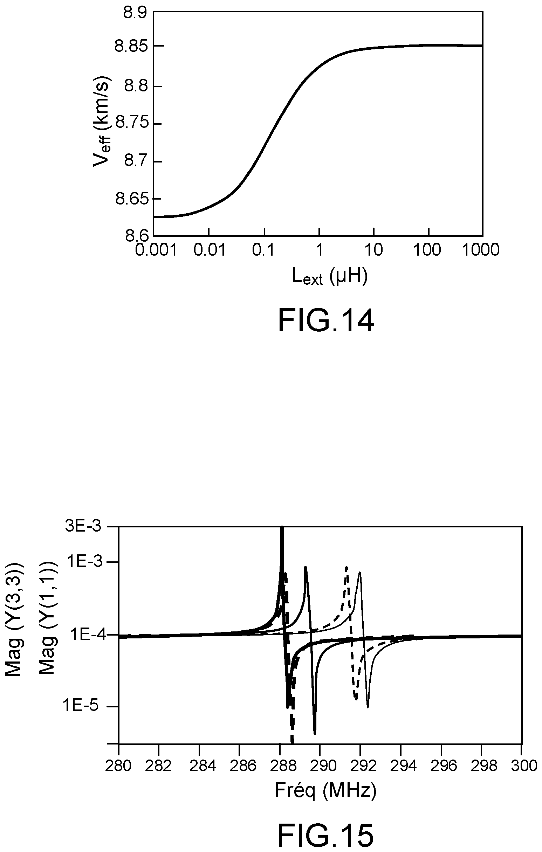

La figure 13 montre les variations de vitesse de l'onde de Lamb S₀ dans l'empilement considéré, qui est l'onde exploitée dans le présent exemple, dans la cavité en fonction du rapport entre une capacité externe appliquée et la capacité de la cavité elle-même. De manière similaire, la figure 14 illustre l'effet d'une inductance externe Lₑₓₜ sur la vitesse de l'onde S₀ dans la cavité. On peut remarquer que l'allure de la variation de vitesse est inversée par rapport à l'utilisation d'une capacité. Enfin la figure 15 montre la variation de fréquence déterminée à partir des variations de vitesse produite par l'ajustement d'une capacité variable externe pour une cavité d'une longueur de 120 µm, les différentes courbes sont relatives à différentes valeurs de la capacité externe pouvant varier de 10pF à 100nF. Y(2,2) est l'admittance du dispositif de référence sur lequel on ne branche pas de capacité externe et Y(3,3) est l'admittance du dispositif sur lequel on branche une capacité variable, les deux courbes pouvant ainsi être traitées comme une seule courbe.

L'exemple présenté ci-dessus montre un dispositif électromécanique avec une cavité d'accord unique et suppose que l'on dispose de moyens permettant d'obtenir des variations de capacités ou d'inductances de l'ordre de plusieurs ordres de grandeur (typiquement d'un facteur 10⁴ d'après les figures 9 et 10).

Il peut être avantageux de décomposer la cavité d'accord correspondant à la zone d'adaptation d'impédance en plusieurs sections que l'on vient piloter indépendamment. Ceci peut d'une part permettre de diminuer les valeurs de la capacité de la cavité à piloter (et donc de réduire les valeurs de capacités maximales à atteindre et à l'inverse d'augmenter la tolérance à une résistance dans le circuit de commande), ce qui devient particulièrement utile dans le cas de l'utilisation de couches piézoélectriques à forte permittivité diélectrique (Niobate de Lithium ou PZT par exemple) et utilisées sur de faibles épaisseurs. D'autre part, afin d'exploiter au mieux les excursions en fréquence possibles, on peut imaginer utiliser un commutateur (intégré ou en technologie MEMS) venant ouvrir ou fermer un circuit vers une capacité fixe (ou formant un circuit ouvert / fermé). On dispose ainsi de tronçons dont on peut faire varier de manière binaire les constantes de propagation de l'onde exploitée.

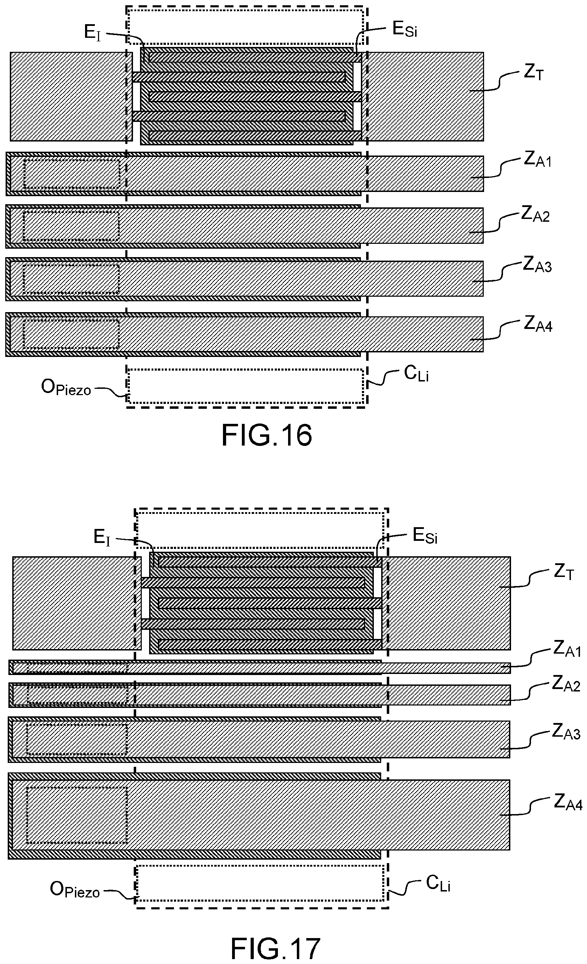

Par un arrangement régulier des cavités, comme celui de la figure 16 qui illustre un exemple à quatre zones d'adaptation d'impédance Z_{A1}, Z_{A2}, Z_{A3} et Z_{A4}, on peut ainsi faire varier la fréquence du résonateur en fonction du nombre de sections dont le commutateur est fermé (ou ouvert).

Une méthode plus avantageuse consiste à décomposer la cavité d'accord en sections dont les longueurs suivent une progression géométrique (par exemple, d'un rapport 2), comme représenté par la figure 17, qui montrent des zones d'adaptation d'impédance Z_{A1}, Z_{A2}, Z_{A3} et Z_{A4} de dimensions variables de manière à pouvoir fixer la fréquence du résonateur en adressant les différentes cavités selon une représentation numérique (en base 2 pour une progression géométrique de rapport 2, par exemple).

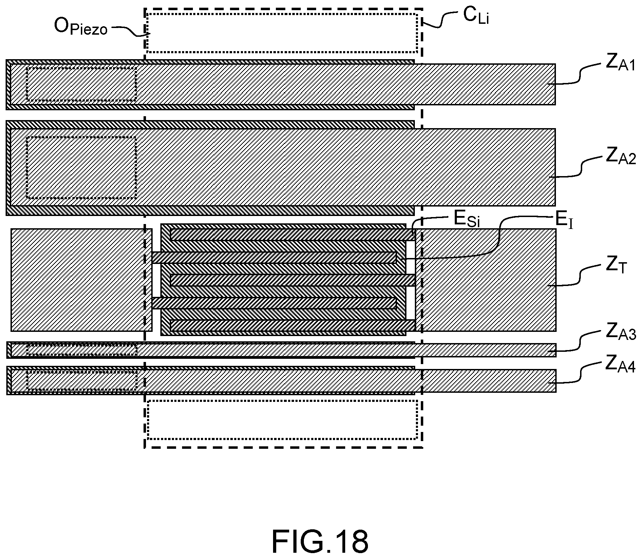

Il est à noter que si la cavité est décomposée en plusieurs tronçons, il n'est pas nécessaire que toutes les zones d'adaptation d'impédance soient à priori disposées dans un ordre particulier, ni même qu'elles soient disposées de manière contigüe. Il est en particulier possible de disposer ces dernières de part et d'autre de la zone de transduction, comme représenté sur la figure 18.

### Exemple de réalisation d'un dispositif électromécanique selon l'invention :

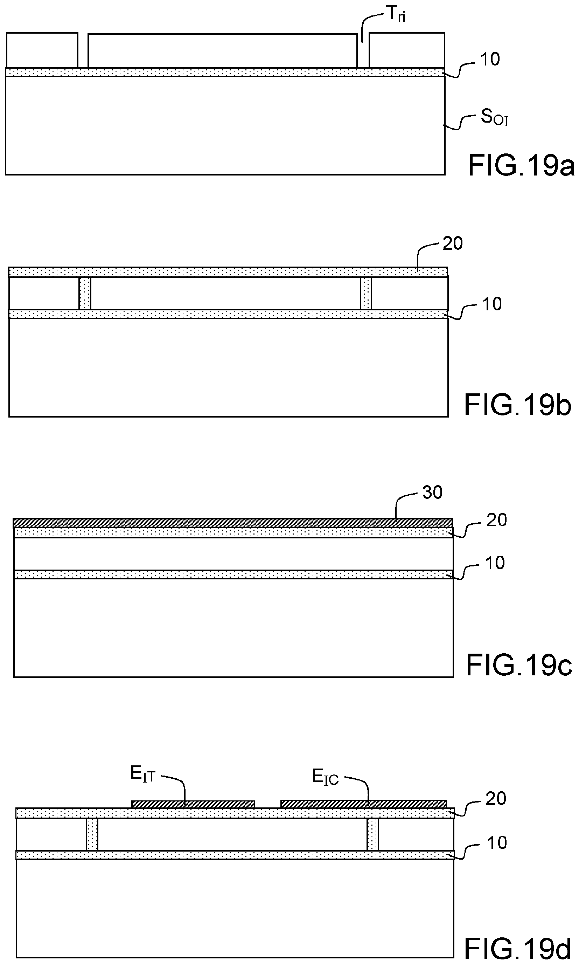

Comme illustré en figure 19a, à partir d'un substrat de type SOI on procède par gravure à la réalisation de tranchées Tri dans la couche supérieure de silicium, atteignant ainsi la couche isolante 10 au sein du SOI.

On procède à une opération d'oxydation thermique dudit substrat et ainsi à la formation d'un caisson d'arrêt de gravure comme illustré en figure 19b, définissant notamment une couche supérieure diélectrique 20.

On réalise à la surface de ladite couche 20, le dépôt d'une couche conductrice 30 en molybdène, comme illustré en figure 19c.

On réalise alors les électrodes inférieures E_{IT} et E_{IC} de la zone de transduction et de la zone d'adaptation d'impédance, dans la couche de molybdène comme illustré en figures 19d, par lithographie, gravure sèche fluorée et retrait de résine.

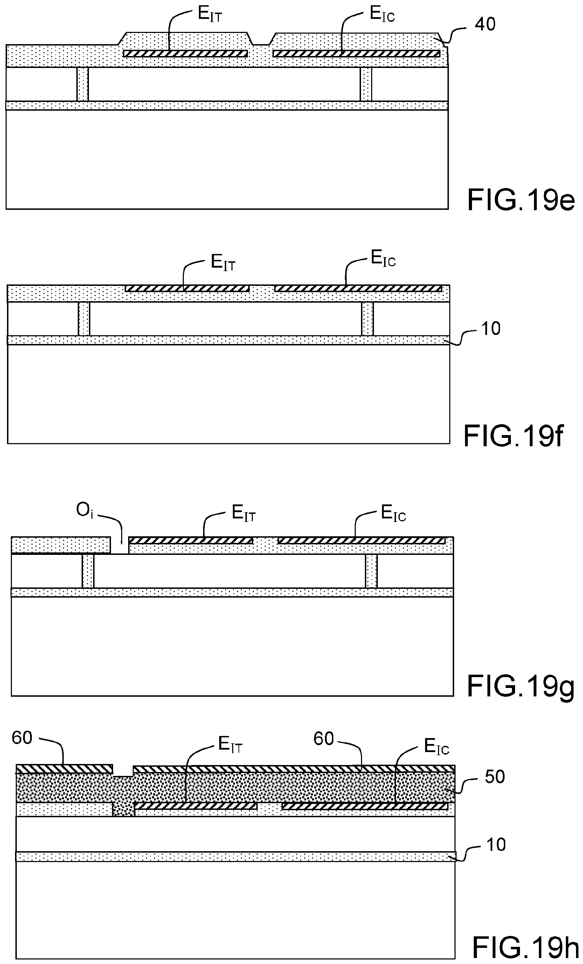

On réalise ensuite un dépôt 40 de SiO₂ de planarisation par PECVD « Plasma Enhanced Chemical Vapor Déposition » comme représenté en figure 19e, puis on procède à une opération de planarisation avec arrêt affleurant les électrodes inférieures comme illustré en figure 19f.

On procède alors à la gravure de marches dans le niveau inférieur pour définir les ouvertures Oi, à flancs verticaux, comme illustré en figure 19g.

On dépose alors une couche 50, de matériau piézoélectrique en AIN par pulvérisation cathodique réactive DC puisée, à la surface de laquelle on dépose une couche supérieure 60 de molybdène par pulvérisation, comme illustré en figure 19h.

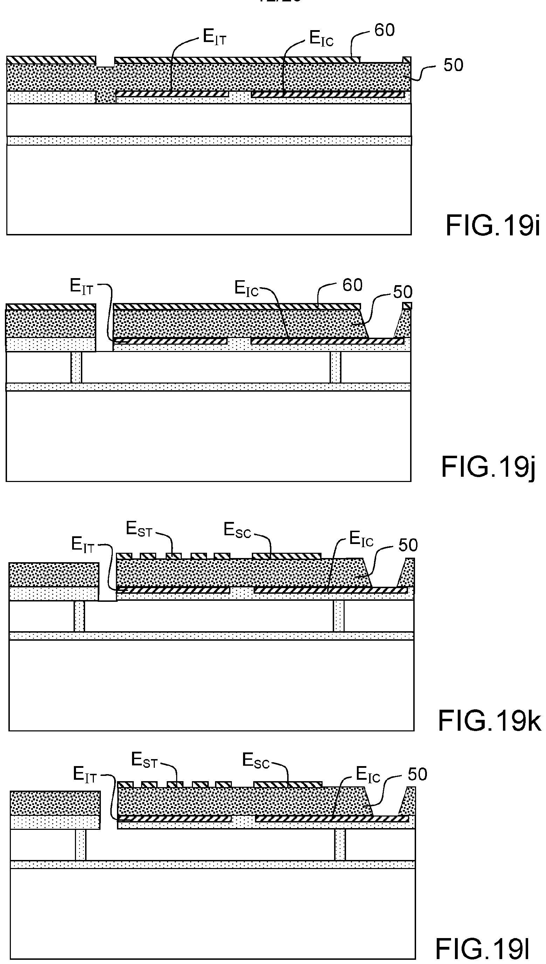

On définit alors un masque dur en molybdène, par lithographie, gravure sèche fluorée et retrait de résine, comme illustré en figure 19i.

On procède à une opération de gravure humide avec une solution de H₃PO₄ à 80°C, pour définir les flancs de membrane et les accès vers les électrodes inférieures comme illustré en figure 19j.

On réalise alors les électrodes supérieures E_{ST} de la zone de transduction et l'électrode supérieure dédiée à la zone d'adaptation de charge E_{SC} par lithographie, gravure sèche fluorée et retrait de résine comme illustré en figure 19k.

On procède enfin à la gravure du silicium dans les caissons par gaz XeF₂ pour libérer la membrane comme illustré en figure 19l.

### Deuxième exemple de procédé de réalisation d'un dispositif électromécanique :

Plutôt que d'utiliser des ondes de Lamb dans une membrane de nitrure d'aluminium, il est également possible, d'utiliser des ondes guidées dans une couche de nitrure d'aluminium isolée par un miroir de Bragg acoustique, en s'inspirant des structures décrites dans l'article de I. Koné, F. Domingue, A. Reinhardt, H. Jacquinot, M. Borel, M. Gorisse, G. Parat, F. Casset, D. Pellissier-Tanon, J.F. Carpentier, L. Buchaillot, B. Dubus, Guided acoustic wave resonators using an acoustic Bragg mirror, Applied Physics Letters 96, 223504 (2010).

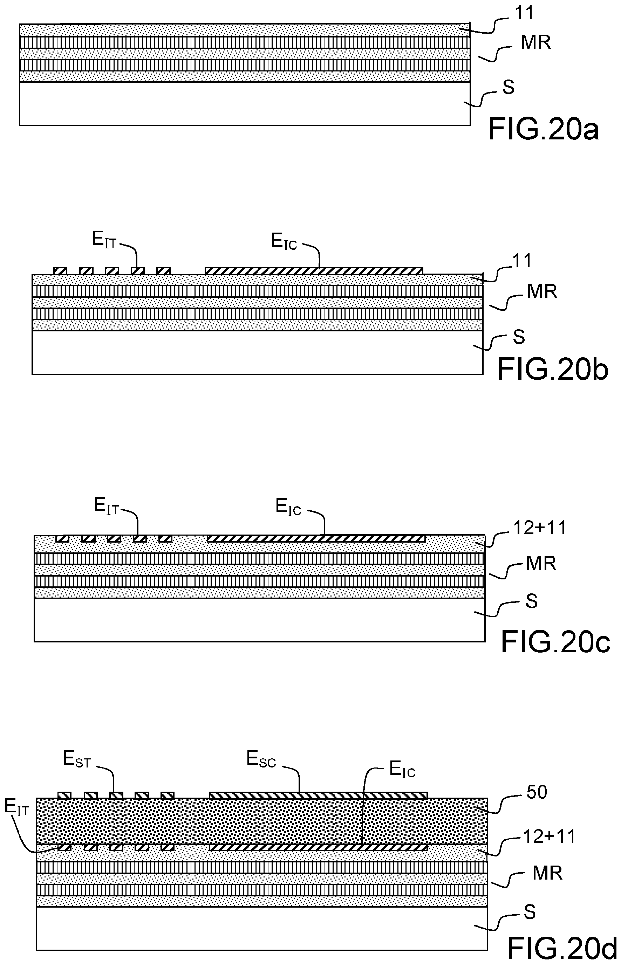

Dans une première étape illustrée en figure 20a, on procède au dépôt d'une alternance de couches de SiOC et de SiN formant le miroir de Bragg MR à la surface d'un substrat S, puis au dépôt d'une couche 11 de SiO₂ à la surface de cet empilement. Toutes ces couches sont déposées par PECVD.

On réalise dans un second temps, le dépôt par pulvérisation d'une couche de molybdène puis les électrodes inférieures par lithographie, gravure sèche fluorée et retrait de résine, comme illustré en figure 20b qui met en évidence les électrodes inférieures E_{IT} et E_{IC} de la zone de transduction et de la zone d'adaptation d'impédance.

On procède alors au dépôt d'une couche supplémentaire 12 de SiO₂ par PECVD, puis planarisation jusqu'à affleurement des électrodes par l'ensemble des couches 11+12, comme illustré en figure 20c.

On procède ensuite au dépôt d'une couche 50 de AIN et au dépôt d'une couche de molybdène, puis à des opérations de lithographie, gravure sèche fluorée et retrait de résine pour définir les électrodes supérieures E_{ST} et E_{SC}, comme illustré en figure 20d.

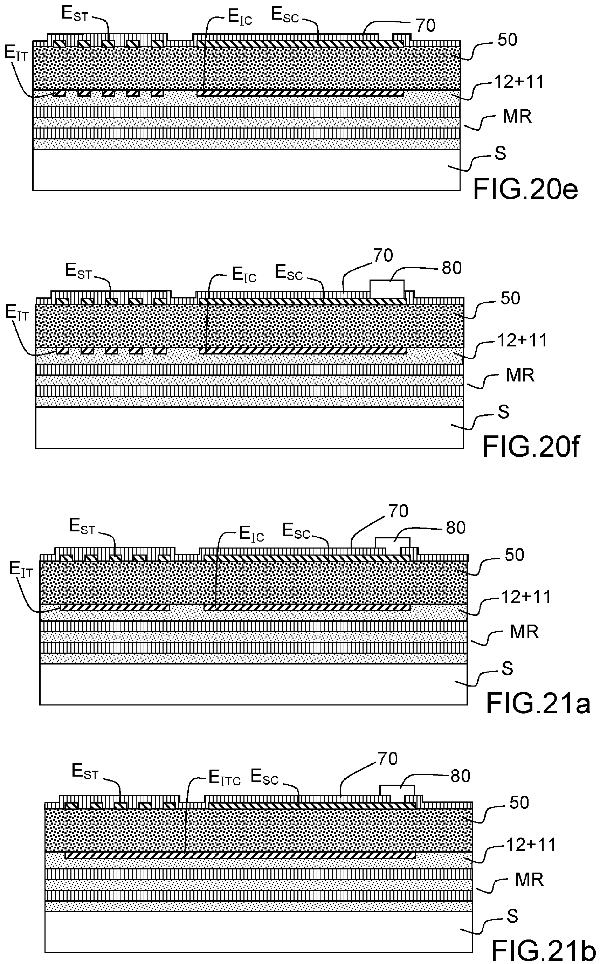

On réalise alors un dépôt par PECVD d'une couche 70 de SiN de passivation. Puis par lithographie, gravure sèche et retrait de résine on dégage des contacts électriques comme illustré en figure 20e.

Enfin on procède au dépôt par pulvérisation d'une couche d'aluminium, lithographie, gravure sèche chlorée et retrait de résine pour former les plots de contact 80, comme illustré en figure 20f.

Il est à noter qu'à l'instar du premier mode de réalisation, le dispositif électromécanique de la présente invention peut comporter différentes alternatives au niveau des électrodes inférieures.

Selon une variante de ce procédé, une électrode continue peut être utilisée sous le transducteur, ce qui simplifie les procédés de lithographie puisque la précision d'alignement nécessaire entre les motifs d'électrode inférieure et supérieure s'en trouve amoindrie. Le procédé de fabrication de cette variante est alors identique, seuls changent les motifs réalisés. La structure ainsi obtenue est représentée sur la figure 21a.

Une autre variante, illustrée en figure 21b, consiste à utiliser une électrode inférieure commune E_{ITC} entre la cavité et le transducteur. Ceci est particulièrement adapté à une structure où le résonateur présente une connexion différentielle (les peignes interdigités sont connectés à des lignes propageant des signaux en opposition de phase l'une par rapport à l'autre). Dans ce cas, l'électrode inférieure est reliée à la masse du circuit d'accord de la cavité, et sert de masse au transducteur également.

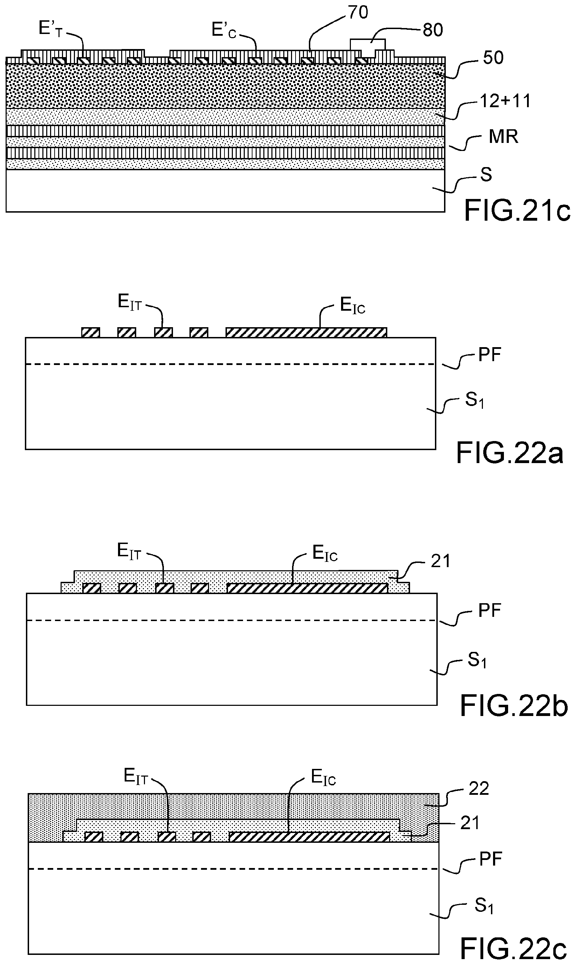

Enfin, il est également possible d'utiliser des modes acoustiques sensibles uniquement à un champ électrique horizontal (cas notamment d'une structure dans laquelle le nitrure d'aluminium voit son axe c cristallographique positionné dans le plan horizontal). Dans ce cas, une électrode inférieure n'est plus nécessaire dans le transducteur. Quant à la cavité, un champ électrique généré par des peignes interdigités réalisés à la surface de la couche piézoélectrique permet d'obtenir l'effet de modification de la vitesse de propagation des ondes voulu. Une telle structure est illustrée sur la figure 21c. Toutefois, pour ne pas perturber la propagation de l'onde, et notamment subir l'effet de filtrage dû au fait que des peignes interdigités E'_{T} et E'_{C} ne peuvent émettre des ondes acoustiques efficacement que dans une bande de fréquences réduite, il est préférable dans ce dernier cas que les métallisations de la cavité présentent une périodicité égale (ou multiple) à celle des peignes dans le transducteur.

Enfin, d'autres matériaux que le nitrure d'aluminium peuvent être employés. Le procédé de réalisation suivant, par exemple, montre comment utiliser des membranes de niobate de lithium.

### Troisième exemple de procédé de réalisation d'un dispositif électromécanique :

Selon une première étape, on procède au nettoyage d'un substrat S1 de niobate de lithium, puis à une opération d'implantation ionique (par Hydrogène ou Hélium) pour former une zone fragilisée PF à une épaisseur déterminée. On réalise un dépôt d'aluminium, puis par photolithographie, gravure sèche, retrait de résine on forme les électrodes inférieures E_{IT} et E_{IC} comme illustré en figure 22a.

On procède ensuite à un dépôt de silicium 21 à basse température, par photolithographie, gravure sèche et retrait de résine, on définit une couche dite sacrifiée, comme illustré en figure 22b.

On procède alors au dépôt d'une couche d'oxyde de silicium 22 à basse température pour réaliser par lithographie, gravure sèche, un contre-masque après retrait de résine et opération de planarisation comme illustré en figure 22c.

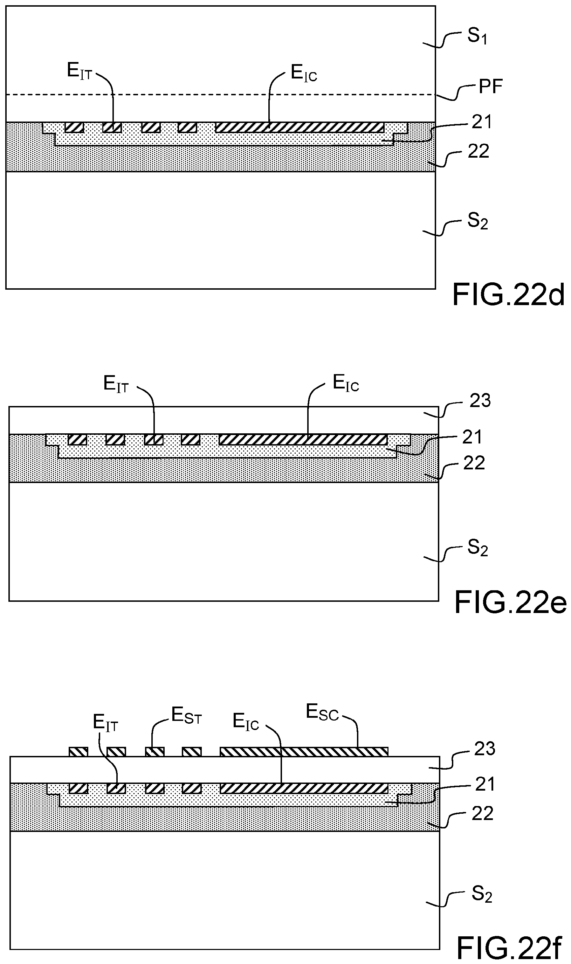

On procède à une opération de collage moléculaire de la plaque sur un substrat dit « hôte » S2 de niobate de lithium comme illustré en figure 22d.

On réalise ensuite par chauffage, la fracture de l'ensemble préconstitué au niveau du substrat de niobate de lithium implanté comme illustré en figure 22e et ce au niveau de la zone fragilisée PF.

On dépose alors une couche d'alumium, puis par lithographie, gravure sèche et retrait de résine on définit les électrodes supérieures E_{ST} et E_{SC} comme illustré en figure 22f.

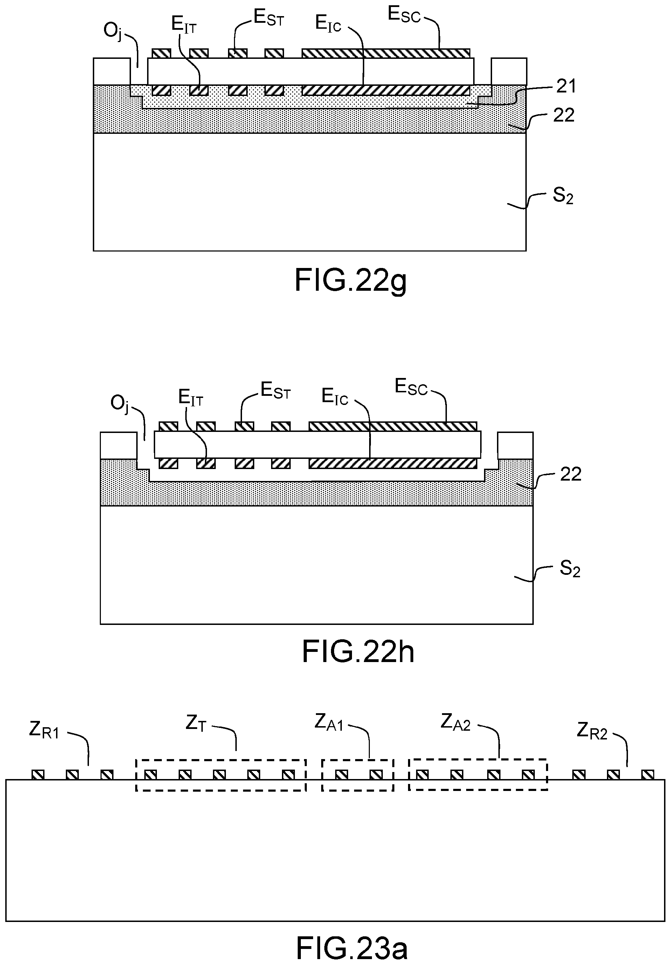

On définit ensuite des ouvertures Oj dans la couche de niobate de lithium par lithographie, gravure sèche et retrait de résine comme illustré en figure 22g.

On procède enfin par gravure par difluorure de xénon gazeux de la couche sacrifiée en silicium amorphe à la libération de la membrane comme illustré en figure 22h.

Il est également possible de décliner cette variante avec une électrode continue sous le transducteur, ou avec une électrode commune entre transducteur et cavité, ou bien encore sans électrode inférieure, auquel cas les métallisations à la surface de la cavité présentent également des motifs en forme de peignes interdigités.

### Quatrième exemple de procédé de réalisation d'un dispositif électromécanique :

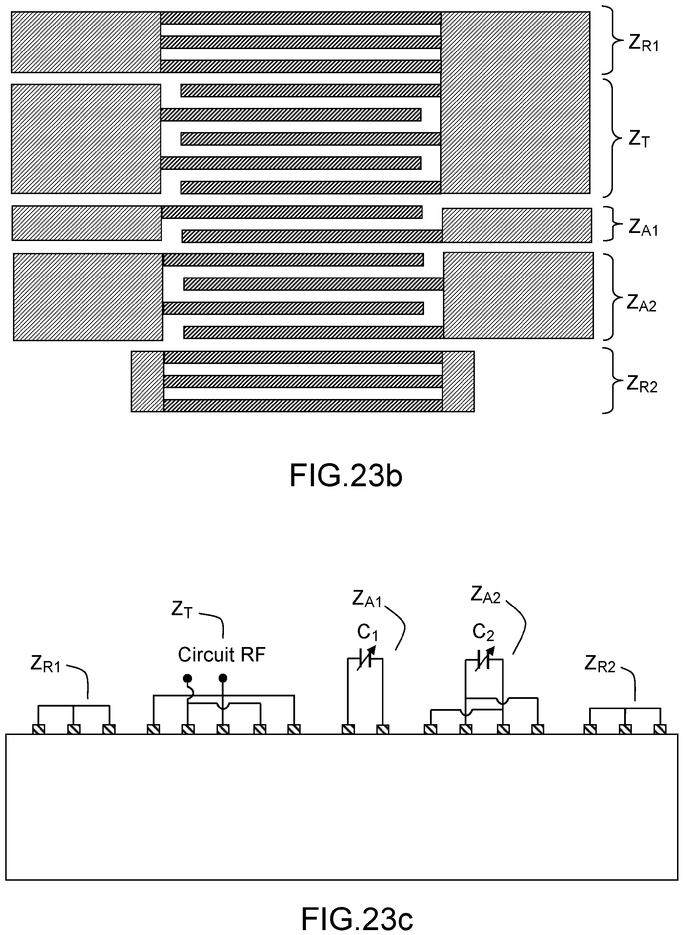

Selon une première étape, on procède au nettoyage d'un substrat de niobate de lithium. On réalise un dépôt d'aluminium, puis par photolithographie, gravure sèche et retrait de résine on forme les électrodes comme illustré en figure 23a. Ces électrodes, représentées sur la figure 23b prennent la forme de peignes interdigités dans le transducteur, dans les zones d'accordabilité en fréquence, et de réflecteurs à peignes interdigités court-circuités dans les zones réflectrices Z_{R1} et Z_{R2} qui délimitent la cavité résonante. On peut remarquer sur ce schéma que la zone d'accordabilité Z_{A2} présente une longueur double de la zone Z_{A1}. La figure 23c représente un schéma électrique du système composé du résonateur accordable et de son électronique de commande.

### Exemple de dispositif électromécanique selon l'invention comprenant des zones de réflexion :

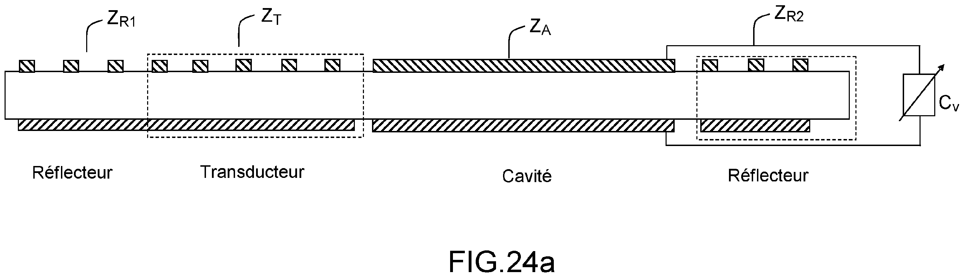

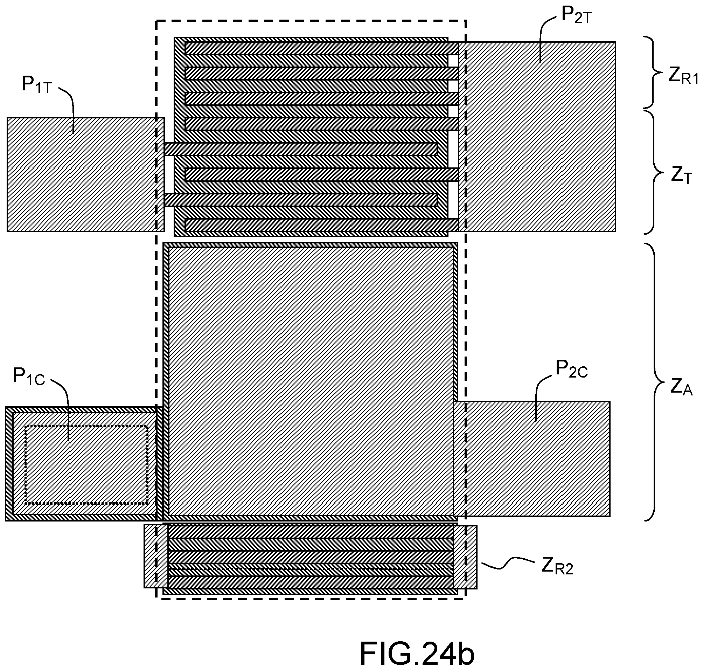

Les exemples de dispositif électromécaniques précédemment décrits utilisaient les bords de structure plane piézoélectrique, il peut être également intéressant que le dispositif de l'invention comprenne des zones de réflexion permettant de délimiter la cavité résonante au-delà de l'exploitation des bords de la structure plane piézoélectrique de la cavité résonante (comme celle illustrée en figure 6). Les figures 24a et 24b illustrent ainsi un exemple de dispositif comprenant des zones de réflexion Z_{R1} et Z_{R2} entourant les zones de transduction Z_{T} et celle d'adaptation d'impédance Z_{A} reliée à une charge variable Cv.

## Revendications

1. Dispositif électromécanique comprenant au moins un résonateur à ondes acoustiques de surface se propageant latéralement dans une structure résonante plane piézoélectrique ou à ondes guidées dans une structure résonante plane piézoélectrique et comprenant au moins des électrodes sur une des faces de ladite structure **caractérisé en ce que** la structure résonante comprend :
- une zone de transduction (Z_{T}) présentant des électrodes pour générer des ondes acoustiques et une longueur de transduction ;
- au moins une zone de propagation libre (Z_{P}) des ondes acoustiques, adjacente à ladite zone de transduction et définie dans le même plan que ladite zone de transduction ;
- la longueur totale de la structure résonante étant égale à un nombre entier de demi-longueurs d'onde (nλ/2), ladite longueur d'onde répondant à l'équation suivante f = V/ À, avec f correspondant à la fréquence de résonance dudit résonateur et V la vitesse moyenne de propagation de l'onde dans la structure, de manière à ajuster le coefficient de qualité du résonateur fixé par la longueur totale de la structure résonante et le coefficient de couplage fixé par le rapport de la longueur de transduction sur la longueur totale de la structure résonante ;
- la structure résonante définie par l'ensemble de la zone de transduction et de la zone de propagation étant délimitée latéralement par des zones de réflexions (F₁, F₂, Z_{R1}, Z_{R2}) ;
- la structure plane piézoélectrique comprenant en outre au moins une zone dite d'accordabilité (Z_{A}) formée par tout ou partie de la zone de propagation et des électrodes d'accordabilité formée sur au moins une des faces de la zone d'accordabilité de façon à définir au moins une capacité C connectée à au moins une impédance extérieure variable, adaptée à faire varier V, la vitesse moyenne de propagation de l'onde dans la structure.

2. Dispositif électromécanique selon la revendication 1, **caractérisé en ce que** la zone de transduction ayant une bande de travail fréquentielle dite de transduction, les zones de réflexions (F₁, F₂, Z_{R1}, Z_{R2}) présentant une bande de travail fréquentielle dite de réflexion, la fréquence de résonance du résonateur est comprise dans les bandes de travail fréquentielles de transduction et de réflexion.

3. Dispositif électromécanique selon l'une des revendications 1 ou 2, **caractérisé en ce que** la structure résonante comprend des bords (F₁, F₂) correspondant à une délimitation physique correspondant à une interface entre le milieu de propagation correspondant à un premier milieu et un second milieu.

4. Dispositif électromécanique selon l'une des revendications 1 à 3, **caractérisé en ce que** chaque impédance extérieure variable est obtenue par une banque de capacités fixes.

5. Dispositif électromécanique selon l'une des revendications 1 à 4, **caractérisé en ce que** tout ou partie des électrodes de la structure forment une ou des structures interdigitées d'électrodes surfaciques, sur une première face de ladite structure.

6. Dispositif électromécanique selon l'une des revendications 3 à 5, **caractérisé en ce que** la zone d'accordabilité ne comporte des électrodes que sur une des faces de la structure dans ladite zone.

7. Dispositif électromécanique selon l'une des revendications 3 à 6, **caractérisé en ce que** la structure comprend en outre au moins une électrode sur la seconde face de ladite structure.

8. Dispositif électromécanique selon l'une des revendications 3 à 7, **caractérisé en ce qu'**il comprend un ensemble de K zones d'accordabilité (Z_{A1}, Z_{A2}, Z_{A3}, Z_{A4}), la zone de transduction étant située entre d'une part M zones d'accordabilité et d'autre part N zones d'accordabilité, avec K = M + N avec M et N, des entiers non nuls.

9. Dispositif électromécanique selon l'une des revendications 3 à 8, **caractérisé en ce que** les zones d'accordabilité ont des longueurs différentes.

10. Dispositif électromécanique selon la revendication 9, **caractérisé en ce que** lesdites longueurs suivent une progression géométrique de type Lₙ=L₀aⁿ, où L₀ est la longueur de la zone d'accordabilité la plus courte, a un facteur de la progression et n est l'indice de la zone.

11. Dispositif électromécanique selon l'une des revendications 3 à 10, **caractérisé en ce que** la zone de transduction et au moins une zone d'accordabilité comprennent une électrode commune.

12. Dispositif électromécanique selon l'une des revendications 1 à 11, **caractérisé en ce que** la structure plane piézoélectrique comporte en outre des zones de réflexions (Z_{R1}, Z_{R2}) comportant des réseaux d'électrodes en périphérie des zones de transduction et de propagation libre.

13. Dispositif électromécanique selon l'une des revendications 1 à 12, **caractérisé en ce que** la structure piézoélectrique est en AlN.

14. Dispositif électromécanique selon l'une des revendications 1 à 12, **caractérisé en ce que** la structure piézoélectrique est en LiNbO₃.

## Patentansprüche

1. Elektromechanische Vorrichtung, welche mindestens einen Resonator mit akustischen Oberflächenwellen beinhaltet, welche sich seitlich in einer ebenen, piezoelektrischen Resonanzstruktur fortpflanzen oder mit geführten Wellen in einer ebenen, piezoelektrischen Resonanzstruktur, und welche mindestens Elektroden auf einer der Seiten der Struktur beinhaltet, **dadurch gekennzeichnet, dass** die Resonanzstruktur Folgendes beinhaltet:
- einen Transduktionsbereich (Z_{T}), welcher Elektroden zum Erzeugen von akustischen Wellen und eine Transduktionslänge aufweist;
- mindestens einen freien Fortpflanzungsbereich (Zp) der akustischen Wellen, welcher an den Transduktionsbereich angrenzt und in derselben Ebene wie der Transduktionsbereich definiert ist;
- wobei die Gesamtlänge der Resonanzstruktur eine Ganzzahl von Wellenhalblängen (nλ/2) beträgt, wobei die Wellenlänge folgende Gleichung erfüllt f = V/λ, wobei f der Resonanzfrequenz des Resonators entspricht und V die mittlere Fortpflanzungsgeschwindigkeit der Welle in der Struktur darstellt, so dass der Qualitätskoeffizient des Resonators, welcher durch die Gesamtlänge der Resonanzstruktur festgelegt wird, und der Kopplungskoeffizient, welcher durch das Verhältnis der Transduktionslänge, geteilt durch die Gesamtlänge der Resonanzstruktur festgelegt wird, eingestellt werden;
- wobei die durch die Gesamtheit des Transduktionsbereichs und des Fortpflanzungsbereichs definierte Resonanzstruktur seitlich durch Reflexionsbereiche (F₁, F₂, ZR₁, Z_{R2}) begrenzt wird;
- wobei die ebene, piezoelektrische Struktur zudem mindestens einen Abstimmbarkeitsbereich (Z_{A}) genannten Bereich beinhaltet, welcher aus der Gesamtheit oder einem Teil des Fortpflanzungsbereichs und der Abstimmbarkeitselektroden besteht, welche auf mindestens einer der Seiten des Abstimmbarkeitsbereichs gebildet sind, um mindestens eine Kapazität C zu definieren, welche mit mindestens einer äußeren variablen Impedanz verbunden ist, die geeignet ist, V, die mittlere Fortpflanzungsgeschwindigkeit der Welle in der Struktur, zu variieren.

2. Elektromechanische Vorrichtung nach Anspruch 1, **dadurch gekennzeichnet, dass**, da der Transduktionsbereich ein Frequenzarbeitsband, genannt Transduktionsband besitzt, und die Reflexionsbereiche (F₁, F₂, ZR₁, Z_{R2}) ein Frequenzarbeitsband, genannt Reflexionsband, aufweisen, die Resonanzfrequenz des Resonators innerhalb der Transduktions- und Reflexions-Frequenzarbeitsbänder liegt.

3. Elektromechanische Vorrichtung nach Anspruch 1 oder 2, **dadurch gekennzeichnet, dass** die Resonanzstruktur Ränder (F₁, F₂) beinhaltet, welche einer physikalischen Begrenzung entsprechen, welche einer Schnittstelle zwischen dem Fortpflanzungsmilieu entspricht, welches einem ersten Milieu und einem zweiten Milieu entspricht.

4. Elektromechanische Vorrichtung nach einem der Ansprüche 1 bis 3, **dadurch gekennzeichnet, dass** jede äußere, variable Impedanz durch eine Bank fester Kapazitäten erzielt wird.

5. Elektromechanische Vorrichtung nach einem der Ansprüche 1 bis 4, **dadurch gekennzeichnet, dass** die Gesamtheit oder ein Teil der Elektroden der Struktur eine oder mehrere interdigitale Strukturen von Oberflächenelektroden auf einer ersten Seite der Struktur bilden.

6. Elektromechanische Vorrichtung nach einem der Ansprüche 3 bis 5, **dadurch gekennzeichnet, dass** der Abstimmbarkeitsbereich Elektroden nur auf einer der Seiten der Struktur in diesem Bereich beinhaltet.

7. Elektromechanische Vorrichtung nach einem der Ansprüche 3 bis 6, **dadurch gekennzeichnet, dass** die Struktur zudem mindestens eine Elektrode auf der zweiten Seite der Struktur beinhaltet.

8. Elektromechanische Vorrichtung nach einem der Ansprüche 3 bis 7, **dadurch gekennzeichnet, dass** sie eine Gruppe von K Abstimmbarkeitsbereichen (Z_{A1}, Z_{A2}, Z_{A3}, Z_{A4}) beinhaltet, wobei der Transduktionsbereich sich einerseits zwischen M Abstimmbarkeitsbereichen und andererseits N Abstimmbarkeitsbereichen befindet, wobei K = M + N, wobei M und N Ganzzahlen ungleich null sind.

9. Elektromechanische Vorrichtung nach einem der Ansprüche 3 bis 8, **dadurch gekennzeichnet, dass** die Abstimmbarkeitsbereiche unterschiedliche Längen besitzen.

10. Elektromechanische Vorrichtung nach Anspruch 9, **dadurch gekennzeichnet, dass** die Längen einer geometrischen Progression vom Typ Lₙ=L₀aⁿ folgen, wobei L₀ die Länge des kürzesten Abstimmbarkeitsbereichs ist, a ein Progressionsfaktor, und n die Indexziffer des Bereichs ist.

11. Elektromechanische Vorrichtung nach einem der Ansprüche 3 bis 10, **dadurch gekennzeichnet, dass** der Transduktionsbereich und mindestens ein Abstimmbarkeitsbereich eine gemeinsame Elektrode beinhalten.

12. Elektromechanische Vorrichtung nach einem der Ansprüche 1 bis 11, **dadurch gekennzeichnet, dass** die ebene, piezoelektrische Struktur zudem Reflexionsbereiche (Z_{R1}, Z_{R2}) beinhaltet, welche Elektrodennetze in der Peripherie der Transduktions- und der freien Fortpflanzungsbereiche beinhalten.

13. Elektromechanische Vorrichtung nach einem der Ansprüche 1 bis 12, **dadurch gekennzeichnet, dass** die piezoelektrische Struktur aus AlN besteht.

14. Elektromechanische Vorrichtung nach einem der Ansprüche 1 bis 12, **dadurch gekennzeichnet, dass** die piezoelektrische Struktur aus LiNbO₃ besteht.

## Claims

1. Electromechanical device comprising at least one resonator using acoustic surface waves propagating laterally within a piezoelectric plane resonant structure or guided waves in a piezoelectric plane resonant structure and at least comprising electrodes on one of the faces of said structure, **characterized in that** the resonant structure comprises:
- a transduction region (Z_{T}) having electrodes for generating acoustic waves and a transduction length;
- at least one free propagation region (Zp) for the acoustic waves, adjacent to said transduction region and defined in the same plane as said transduction region;
- the total length of the resonant structure being equal to an integer number of half-wavelengths (nλ/2), said wavelength complying with the following equation f = V/λ, with f corresponding to the resonance frequency of said resonator and V the average velocity of propagation of the wave within the structure, so as to adjust the quality factor of the resonator fixed by the total length of the resonant structure and the coupling coefficient fixed by the ratio of the transduction length over the total length of the resonant structure;
- the resonant structure defined by the assembly of the transduction region and of the propagation region being laterally bounded by reflection regions (F₁, F₂, Z_{R1}, Z_{R2});
- the piezoelectric plane structure furthermore comprising at least one region referred to as tunability region (Z_{A}) formed by all or part of the propagation region and tunability electrodes formed on at least one of the faces of the tunability region so as to define at least one capacitor C connected to at least one external variable impedance adapted to vary V, the average velocity of propagation of the wave within the structure.

2. Electromechanical device according to claim 1, **characterized in that** the transduction region having a working frequency band referred to as transduction frequency band, and the reflection regions (F₁, F₂, Z_{R1}, Z_{R2}) having a working frequency band referred to as reflection frequency band, the resonance frequency of the resonator is included within the transduction and reflection working frequency bands.

3. Electromechanical device according to one of claims 1 or 2, **characterized in that** the resonant structure comprises edges (F₁, F₂) corresponding to a physical bounding corresponding to an interface between the propagation medium corresponding to a first medium and a second medium.

4. Electromechanical device according to one of claims 1 to 3, **characterized in that** each external variable impedance is obtained by a bank of fixed capacitors.

5. Electromechanical device according to one of claims 1 to 4, **characterized in that** all or part of the electrodes of the structure form an interdigitated structure, or interdigitated structures, of surface electrodes on a first face of said structure.

6. Electromechanical device according to one of claims 3 to 5, **characterized in that** the tunability region only comprises electrodes on one of the faces of the structure in said region.

7. Electromechanical device according to one of claims 3 to 6, **characterized in that** the structure furthermore comprises at least one electrode on the second face of the said structure.

8. Electromechanical device according to one of claims 3 to 7, **characterized in that** it comprises a set of K tunability regions (Z_{A1}, Z_{A2}, Z_{A3}, Z_{A4}), the transduction region being included between, on the one hand, M tunability regions and, on the other hand, N tunability regions, with K = M + N, M and N being non-zero integers.

9. Electromechanical device according to one of claims 3 to 8, **characterized in that** the tunability regions have variable lengths.

10. Electromechanical device according to claim 9, **characterized in that** said lengths follow a geometrical progression of the Lₙ=L₀aⁿ type, where L₀ is the length of the shortest tunability region, a is a factor of the progression and n is the index of the region.

11. Electromechanical device according to one of claims 3 to 10, **characterized in that** the transduction region and at least one tunability region comprise a common electrode.

12. Electromechanical device according to one of claims 1 to 11, in which the piezoelectric plane structure furthermore comprises reflection regions (Z_{R1}, Z_{R2}) comprising arrays of electrodes on the periphery of the transduction and free propagation regions.

13. Electromechanical device according to one of claims 1 to 12, **characterized in that** the piezoelectric structure is made of AlN.

14. Electromechanical device according to one of claims 1 to 12, **characterized in that** the piezoelectric structure is made of LiNbO₃
